(19) Europäisches Patentamt

European Patent Office

Office européen des brevets

(11) **EP 0 849 798 B1**

(12) **FASCICULE DE BREVET EUROPEEN**

(45) Date de publication et mention
de la délivrance du brevet:
**31.05.2006 Bulletin 2006/22**

(51) Int Cl.:
*H01L 25/04* *(2006.01)*    *H01L 27/146* *(2006.01)*

(21) Numéro de dépôt: **97402894.6**

(22) Date de dépôt: **02.12.1997**

(54) **Détecteur photoconducteur**

Photoleitender Detektor

Photoconductive detector

(84) Etats contractants désignés:
**DE GB**

(30) Priorité: **04.12.1996 FR 9614851**

(43) Date de publication de la demande:
**24.06.1998 Bulletin 1998/26**

(73) Titulaire: **Thales**
**75008 Paris (FR)**

(72) Inventeurs:
• **Costard, Eric**
**94117 Arcueil Cedex (FR)**
• **Bois, Philippe**
**94117 Arcueil Cedex (FR)**
• **Herniou, Eric**
**94117 Arcueil Cedex (FR)**
• **Audier, Marcel**
**94117 Arcueil Cedex (FR)**

(56) Documents cités:
**EP-A- 0 345 972**      **EP-A- 0 481 552**
**US-A- 5 552 603**

## Description

L'invention concerne un détecteur d'ondes électromagnétiques et notamment un détecteur fonctionnant par photoconduction.

Plus particulièrement, l'invention concerne une architecture de détecteur qui permet de supprimer le courant d'obscurité et le photocourant généré par la scène observée en amont du circuit de lecture.

Les systèmes de détection infrarouge de type matriciel et hybridés sur un circuit de lecture en silicium sont limités en dynamique et en température de fonctionnement par les courants d'obscurité et de scène. A chaque pixel de la matrice active de détection correspond un circuit d'intégration et de lecture sur la puce silicium. Plus le format de la matrice augmente, plus la surface disponible par pixel pour le circuit de lecture et en particulier la capacité de stockage diminuent (la surface disponible pour le circuit de lecture d'un pixel d'une matrice de format supérieur à $256^2$ est inférieur à 30 x 30 $\mu$m$^2$). Les courants de fond et d'obscurité génèrent un offset qui limite la capacité de stockage du signal utile. Le courant d'obscurité varie exponentiellement avec la température de fonctionnement de la matrice de détection. Une autre voie consiste à réaliser cet ébasage en courant au niveau du circuit de lecture silicium. Toutefois, cette nouvelle fonction du circuit Si génère du bruit et empiète sur la surface de la capacité de stockage.

Il est connu selon l'art antérieur US 5 552 603, de réaliser un détecteur multilongueurs d'ondes en empilant au moins deux éléments détecteurs actifs. Néanmoins, il n'est pas proposé de moyens spécifiques pour résoudre le problème de courant d'obscurité.

L'invention concerne donc un détecteur d'onde électromagnétique à photoconducteur comportant :

- au moins deux éléments détecteurs actifs à photoconducteurs empilés de forme plane séparés par une couche commune ;
- un premier moyen de connexion connecté en commun aux deux éléments détecteurs, un deuxième moyen de connexion connecté au premier élément détecteur, et un troisième moyen de connexion connecté au deuxième élément détecteur ;
- des moyens pour appliquer des tensions de commande à chaque moyen de connexion, un potentiel appliqué au premier moyen de connexion ayant une valeur comprise entre les potentiels appliqués aux deuxième et troisième moyens de connexion ;
- des moyens connectés au premier moyen de connexion pour détecter des courants de photoconduction des deux éléments détecteurs, lesdits courants comprenant des courants dus à la longueur d'onde à détecter ($I_1$, $I_2$) et des courants d'obscurité ou des courants d'obscurité et des courants de scène ($I_{1opt}$, $I_{2opt}$),

caractérisé en ce que :

- les deux éléments détecteurs sont photoconducteurs à la même longueur d'onde ;
- la tension de commande appliquée au deuxième moyen de connexion ($V_1$) ou la tension de commande appliquée au troisième moyen de connexion ($V_2$) est ajustée de manière à ajuster les courants d'obscurité ($I_{1d}$, $I_{2d}$) dans les deux éléments détecteurs actifs ($D_1$, $D_2$) ;
- les moyens pour détecter les courants de photoconduction des deux éléments détecteurs, détectent la différence entre les courants dus à la longueur d'onde $\lambda(I_1-I_2)$.

Les différents objets et caractéristiques de l'invention apparaîtront plus clairement dans la description qui va suivre et dans les figures annexées qui représentent :

- la figure 1a, un exemple simplifié de détecteur selon l'invention ;
- la figure 1b, un circuit électrique de montage du détecteur selon l'invention ;
- la figure 2, un exemple de réalisation détaillé du détecteur selon l'invention ;
- les figures 3a et 3b, une matrice de détecteurs selon l'invention en vue de dessus et en vue de coupe ;
- les figures 4a à 4c, un exemple de procédé de réalisation du détecteur selon l'invention ;
- les figures 5 à 9, des variantes de réalisation de l'invention.

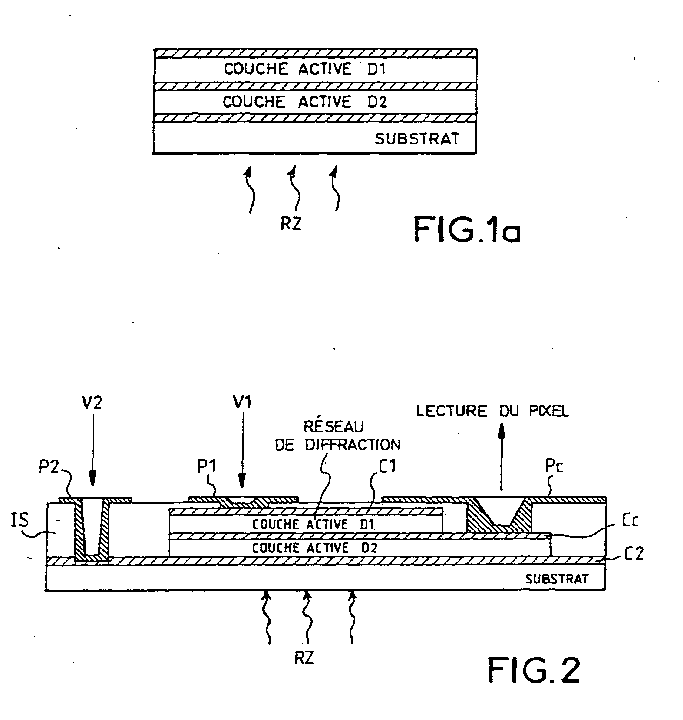

Comme cela est représenté de façon simplifiée sur la figure 1a, le détecteur selon l'invention comporte empilées sur un substrat :

- une couche de contact C2 .
- une couche active photoconductrice D2
- une couche de contact commune Cc
- une couche active photoconductrice D1
- et une couche de contact C1

Les couches actives photoconductrices D1, D2 peuvent être des couches en semiconducteur photoconducteur tel que du silicium. Elles peuvent être également réalisées sous forme d'empilement de couches constituant des détecteurs à puits quantiques. Les deux couches actives D1, D2 sont photoconductrices à la même longueur d'onde $\lambda$. L'une des couches actives est conçue pour être très absorbante à la longueur d'onde $\lambda$ tandis que l'autre couche est prévue pour être très peu ou quasiment pas absorbante. Cela peut être prévu par des épaisseurs différentes des couches actives, ou par dopage plus important des couches de puits quantiques de la couche active plus absorbante.

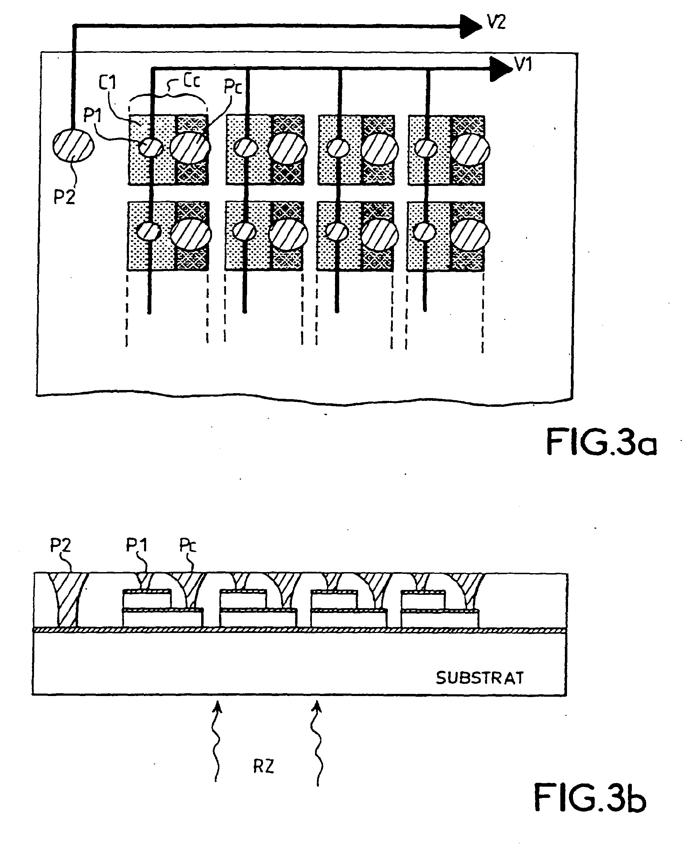

Le détecteur étant éclairé par le rayonnement à détecter comme cela est représenté en figures 1a et 2, la couche active D2 reçoit en premier le rayonnement.

Dans le cas où la couche D1 est plus absorbante que la couche D2, on peut prévoir, associé à la face de la couche D1 qui porte la couche de contact C1, un réseau de diffraction. Ce réseau reçoit la lumière qui n'a pas été absorbée lors de la première traversée de la couche D1 et la diffracte vers la couche D1. La lumière diffractée sera absorbée ou quasi absorbée par la couche D1.

Dans le cas où la couche D2 a une réponse nettement supérieure à celle de la couche D1, elle absorbe la quasi-totalité de rayonnement à la longueur d'ondes. De plus, la couche Cc peut être prévue pour bloquer la longueur d'onde $\lambda$. Cette couche peut être par exemple métallique ou en semiconducteur qui bloque la longueur d'onde $\lambda$.

Les couches de contacts C1 et C2 permettent l'application de potentiels de commande. La couche de contact Cc est commune aux deux éléments détecteurs comprenant les couches actives photoconductrices.

Elle est mise à un potentiel de référence et permet la détection des photocourants générés par les détecteurs D1, D2.

La figure 2a représente une réalisation plus détaillée du détecteur de l'invention selon laquelle le détecteur est encapsulé dans un matériau isolant IS. Les plots de contacts P1, P2, Pc traversent cet isolant et permettent la prise de contacts sur les couches de contact C1, C2, Cc respectivement.

Le substrat est transparent à la longueur d'onde à mesurer. Le détecteur reçoit donc le rayonnement RZ à travers le substrat.

Lorsqu'un rayonnement RZ est reçu par le détecteur, pour détecter la longueur d'onde $\lambda$ (ou gamme de longueurs d'ondes) on applique :

- un potentiel V1 à la couche de contact C1
- un potentiel V2 à la couche de contact C2
- un potentiel Vc flottant (ou masse) compris entre V1 et V2 à la couche de contact commune Cc.

Dans la structure D1 circule un courant

$$I1 = I1d + I1opt$$

et dans la structure D2 circule un courant

$$I2 = I2d + I2opt$$

Les courants I1d et I2d sont les courants d'obscurité dans D1 et D2. Les courants I1d et I2d peuvent également représenter la somme d'un courant d'obscurité et d'un courant de scène. Les courants I1opt et I2opt sont les courants dus à la longueur d'onde $\lambda$ à détecter dans D1 et D2.

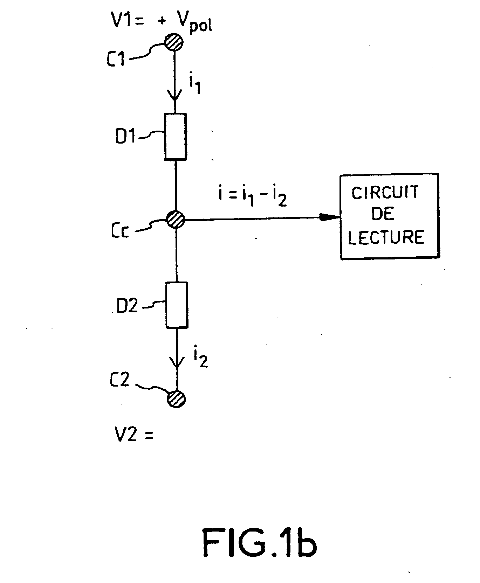

Selon la figure 1b, le courant i collecté par le circuit de lecture a pour valeur :

$$I = I1 - I2$$

En ajustant la tension V1 ou V2, il est possible d'ajuster I1d = I2d. La valeur du courant détecté est donc :

$$I = I1opt - I2opt$$

En prévoyant que l'une des deux couches actives n'absorbe que très peu d'énergie de l'onde $\lambda$, le courant I est donc celui généré par la couche active qui a la réponse la plus forte.

Les figures 3a et 3b représentent en vue de dessus et en coupe une forme de réalisation matricielle d'un détecteur bispectral selon l'invention.

Les différents détecteurs sont réalisés sur une couche de contact de commande C2 commune à tous les détecteurs. Le plot de connexion P2 est donc commun à toute la matrice. Chaque détecteur de la matrice comporte un élément détecteur D1 et un élément détecteur D2 ainsi que les couches de contacts C1 et Cc et les plots de connexion P1 et Pc. Les plots de connexion P1 sont tous connectés entre eux pour appliquer un potentiel V1 (voir précédemment) à tous les éléments détecteurs D1 de la matrice. La couche de contact C2 et le plot de connexion P2 étant communs à toute la matrice, le potentiel V2 appliqué au plot P2 est appliqué à tous les éléments détecteurs D2 de la matrice.

Pour la lecture des détecteurs de la matrice, chaque détecteur est situé au point de croisement d'un réseau de conducteurs de lignes et de colonnes. Sur la figure 3c, on n'a représenté uniquement que le plot de connexion Pc de chaque détecteur. A chaque point de croisement est prévu par exemple un transistor Tr dont la base est connectée au fil de ligne. L'émetteur et le collecteur sont connectés respectivement à un plot Pc et à fil de colonne. L'application d'un potentiel approprié sur un fil de ligne permet de commander tous les transistors de la ligne et de connecter tous les plots Pc d'une ligne à des fils de colonne. Il est ainsi possible de lire, sur chaque fil de colonne, le photocourant généré par le détecteur connecté à ce fil de colonne.

Dans cet exemple de réalisation, toutes les couches C1 sont interconnectées entre elles et commandées par un même potentiel. Il en est de même pour les couches de contacts C2 qui sont connectées au plot P2.

Cependant, selon une variante de réalisation, on prévoit que la couche de contact de commande C2 est découpée en bandes de façon que chaque bande soit commune à une ligne de détecteurs. On aura alors un plot P2 par bande de contact C2, c'est-à-dire par ligne de détecteurs.

De façon similaire, au lieu d'interconnecter tous les plots P1, on les interconnecte par lignes de détecteurs. On a un plot P1 par ligne de détecteurs.

Les plots Pc des détecteurs sont interconnectés par des fils de colonnes de la matrice.

Le fonctionnement de la matrice de détecteurs se fait alors séquentiellement par ligne.

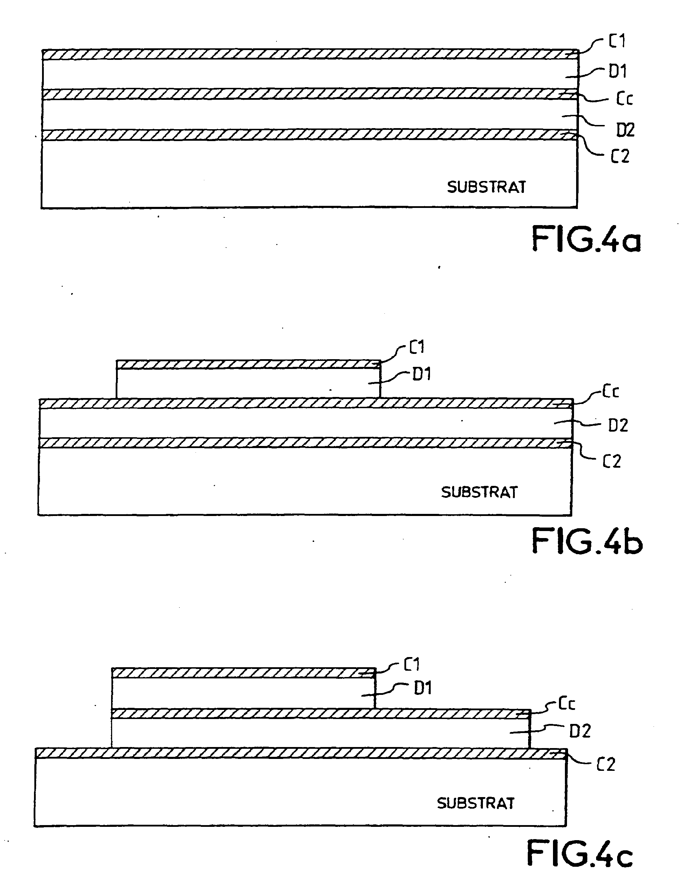

En se reportant aux figures 4a à 4c, on va maintenant décrire un procédé de réalisation d'un détecteur selon l'invention.

Sur un substrat en matériau transparent aux longueurs d'ondes à détecter, on réalise successivement une couche de contact C2, une ou plusieurs couches photoconductrices D2 constituant l'élément photodétecteur D2, une couche de contact commune Cc, une ou plusieurs couches photoconductrices D1 constituant l'élément photodétecteur D, une couche de contact C1 (figure 4a).

L'élément détecteur supérieur D1 est déterminé par la gravure des couches C1 et D1 avec arrêt de la gravure sur la couche de contact Cc (figure 4b).

L'élément détecteur inférieur D2 est ensuite déterminé par la gravure des couches Cc et D2 avec arrêt de la gravure sur la couche de contact C2 (figure 3c).

L'ensemble est ensuite recouvert d'une couche d'isolant IS (figure 2).

Ensuite trois trous sont réalisés dans la couche d'isolant de façon à accéder aux trois couches de contact et des dépôts métalliques sont réalisés dans ces trous pour obtenir les plots de contacts P1, P2 et Pc.

Pour la réalisation d'une matrice de détecteurs, les différents détecteurs sont réalisés collectivement comme décrit précédemment. On obtient alors une structure telle que représentée en figure 3b. Comme on l'a vu, le plot P2 est commun à toute la matrice. Il ne reste donc plus qu'à réaliser à la surface de la matrice les conducteurs d'interconnexion des plots P1 puis le réseau matriciel de connexion des plots Pc.

Dans ce qui précède, on a décrit l'invention en réalisant des détecteurs à transport vertical comme les détecteurs à multipuits quantiques. On va maintenant décrire l'invention avec des détecteurs à transport horizontal.

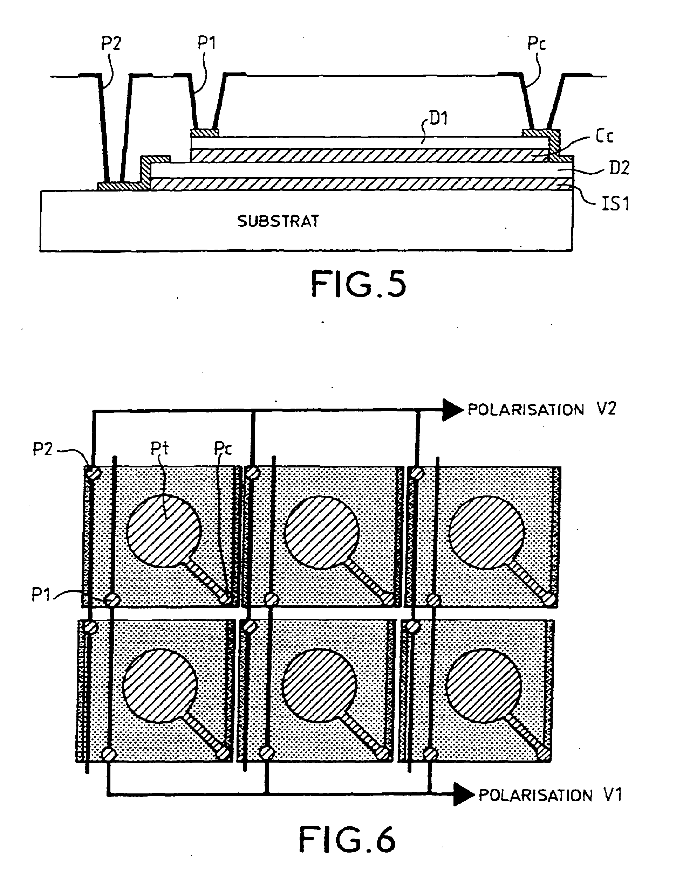

Le détecteur se compose de deux couches actives séparées par une couche isolante Cc (voir figure 5).

Des contacts ohmiques sont définis aux deux extrémités de chaque couche active D1, D2. A l'une des extrémités du détecteur, les contacts ohmiques sont mis en commun pour définir le contact de lecture Pc. Ce contact Pc (un contact par pixel) assurera la connexion avec l'étage d'entrée du circuit de lecture. Le contact inférieur P2 est relié à la couche active D2. Le contact supérieur P1 est relié à la couche active D1. On voit donc que lorsque les couches actives sont convenablement polarisées, le détecteur a un fonctionnement similaire à celui décrit précédemment avec la différence qu'on a une circulation de courant selon le plan des couches actives au lieu de perpendiculairement au plan des couches actives.

Sur la figure 5, on a prévu une couche d'isolant IS1 entre la couche active D2 et le substrat.

La figure 6 représente une organisation matricielle de détecteurs tels que ceux de la figure 5. Dans cette organisation, tous les contacts P1 sont connectés ensembles par des fils de colonnes. Il en est de même pour les contacts P2 et Pc. Un plot central dé test Pt par détecteur permet de faire un test de courant.

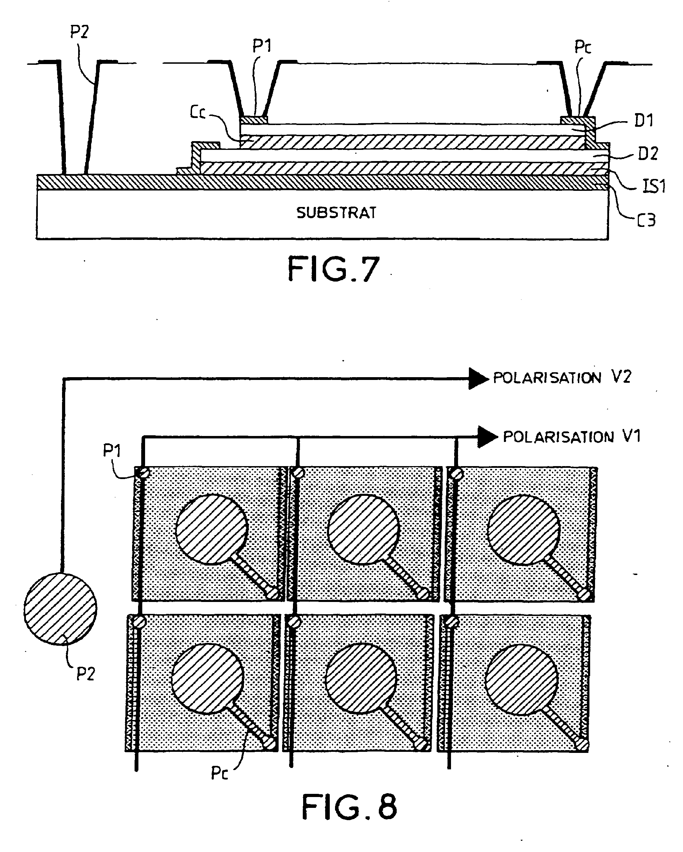

La figure 7 représente une variante de réalisation de la figure 5 comportant une couche conductrice C3 disposée sur le substrat et sur laquelle est réalisée la structure de la figure 5.

La figure 8 représente une organisation matricielle de détecteurs de la figure 7. La couche C3 permet dans cette organisation matricielle d'avoir un plot de connexion P2 unique et commun à tous les pixels détecteurs.

Un certain nombre de possibilités supplémentaires peuvent être utilisées :

- possibilité de prévoir des réseaux de diffraction gravés sur le dessus du détecteur pour minimiser l'épaisseur de la couche active et augmenter la détectivité du dispositif ; ils permettront également de dissymétriser la réponse des deux étages ;

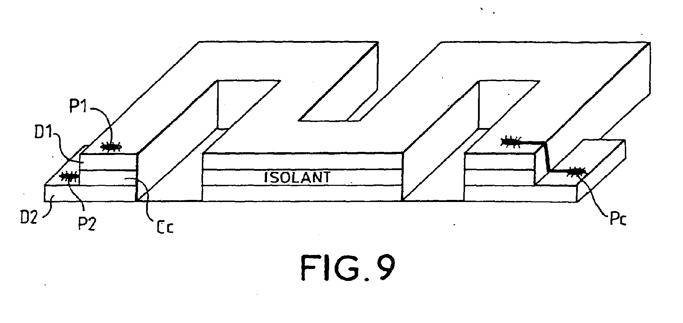

- possibilité de réaliser une géométrie « serpentin » (voir figure 9) qui permet d'augmenter la résistance du pixel (augmentation de la longueur développée et diminution de la surface équivalente électrique pour une surface optique sensiblement identique) ; cette géométrie donne également un peu de souplesse en ce qui concerne les défauts métallurgiques car ceux-ci ne créent plus alors que des courts-circuits locaux.

**Revendications**

1. Détecteur d'onde électromagnétique à photoconducteur comportant:

    - au moins deux éléments détecteurs actifs à photoconducteurs (D1, D2) empilés de forme plane séparés par une couche commune (Cc) ;
    - un premier moyen de connexion (Pc) connecté en commun aux deux éléments détecteurs, un deuxième moyen de connexion (P1) connecté au premier élément détecteur, et un troisième moyen de connexion connecté au deuxième élément détecteur (P2) ;
    - des moyens pour appliquer des tensions de commande (V1, V2) à chaque moyen de connexion, un potentiel appliqué au premier moyen de connexion ayant une valeur comprise entre les potentiels (V1, V2) appliqués aux deuxième et troisième moyens de connexion ;
    - des moyens connectés au premier moyen de connexion pour détecter des courants de photoconduction des deux éléments détecteurs, lesdits courants comprenant des courants dus à la longueur d'onde à détecteur ($I_1$, $I_2$) et des courants d'obscurité ou des courants d'obscurité et des courants de scène ($I_{1opt}$, $I_{2opt}$),

**caractérisé en ce que** :

- les deux éléments détecteurs sont photoconducteurs à la même longueur d'onde ;
- la tension de commande appliquée au deuxième moyen de connexion ($V_1$) ou la tension de commande appliquée au troisième moyen de connexion ($V_2$) est ajustée de manière à ajuster les courants d'obscurité ($I_{1d}$, $I_{2d}$) dans les deux éléments détecteurs actifs ($D_1$, $D_2$) ;
- les moyens pour détecter les courants de photoconduction des deux éléments détecteurs, détectent la différence entre les courants dus à la longueur d'onde $\lambda(I_1 - I_2)$.

2. Détecteur selon la revendication 1, **caractérisé en ce que** la couche commune (Cc) est une couche de contact électrique, le premier moyen de connexion (Cc) étant connecté à cette couche commune et **en ce que** l'ensemble des deux éléments détecteurs est enserré entre deux couches de contact de commande électrique (C1, C2), le deuxième et le troisième moyens de connexion (P1, P2) étant connectés chacun à une couche de contact de commande.

3. Détecteur selon la revendication 1, **caractérisé en ce que** la couche commune (Cc) est une couche isolante, **en ce que** le premier moyen de connexion est connecté à une première extrémité de chaque élément détecteur, et **en ce que** le deuxième et le troisième moyens de connexion sont connectés chacun à une deuxième extrémité d'un élément détecteur, la première extrémité et la deuxième extrémité de chaque élément détecteur étant des extrémités opposées dudit élément détecteur.

4. Détecteur selon la revendication 1, **caractérisé en ce que** la réponse de l'un des éléments détecteurs est nettement supérieure à la réponse de l'autre élément détecteur de telle façon qu'il absorbe la quasi-totalité de l'énergie lumineuse à la longueur d'onde pour laquelle il est photoconducteur.

5. Détecteur selon l'une des revendications 1 ou 2, **caractérisé en ce que** la couche commune (Cc) n'est pas transparente à la longueur à détecter de façon que la couche active de l'un des éléments détecteurs (D1) ne reçoive pas cette longueur d'onde.

6. Détecteur selon la revendication 1, **caractérisé en ce que** l'un des potentiels du deuxième ou troisième moyens de connexion est ajusté de façon que les courants d'obscurité ou les sommes des courants d'obscurité et de scène des deux éléments détecteurs soient égaux.

7. Détecteur **caractérisé en ce qu'**il comporte une matrice de détecteurs selon la revendication 2, réalisé sur un substrat, une première couche de contact de commande (C2) étant sur la face du substrat et étant commune à tous les détecteurs, chaque détecteur comportant, sur cette première couche de contact de commande, un premier élément détecteur (D2) en matériau photoconducteur, une couche de contact de lecture (Cc), un deuxième élément détecteur (D1) en matériau photoconducteur, une deuxième couche de contact de commande (C2), les deuxièmes couches de contact de commande (C2) des différents détecteurs de la matrice étant interconnectées entre elles.

8. Détecteur selon la revendication 7, **caractérisé en ce qu'**il comporte une matrice de conducteurs de lignes et de conducteurs de colonnes superposée à la matrice de détecteurs, chaque détecteur étant localisé sensiblement à un point de croisement de la matrice de conducteurs de lignes et de colonnes et étant connectable au fil de colonne du point de croisement par un dispositif de commutation commandable par un potentiel appliqué au fil de ligne du point de croisement.

9. Détecteur selon la revendication 7, **caractérisé en ce que** :

- la première de couche de contact de commande (C2) est réalisée sous forme de bandes, une ligne de détecteurs étant réalisée sur chaque bande ;

**en ce que** :

- les deuxièmes couches de contact des détecteurs de chaque ligne de détecteurs sont également interconnectées ensemble ;
- et **en ce que** les couches de contact de lecture d'un détecteur de chaque ligne de détecteurs sont interconnectées ensemble pour former des colonnes de détecteurs.

10. Détecteur **caractérisé en ce qu'**il comporte une matrice de détecteurs selon la revendication 3, réalisé sur un substrat, une couche conductrice (C3) étant sur la face du substrat et étant commune à tous les détecteurs, cette couche étant recouverte par une couche isolante (IS1), chaque détecteur comportant, sur cette couche isolante, un premier élément détecteur (D2) en matériau photoconducteur, une couche commune isolante (Cc), un deuxième élément détecteur (D1) en matériau photoconducteur, les deuxièmes éléments de connexion étant connectés entre eux ainsi que les troisièmes éléments de connexion.

**Claims**

1. Photoconductor-based electromagnetic wave detector including:

 - at least two overlaid plane active photoconductor-based detector elements (D1, D2) separated by a common layer (Cc);
 - a first means of connection (Pc) connected in common to the two detector elements, a second means of connection (P1) connected to the first detector element, and a third means of connection connected to the second detector element (P2);
 - means for applying control voltages (V1, V2) to each means of connection, a potential applied to the first means of connection having a value lying between the potentials (V1, V2) applied to the second and third means of connection;
 - means connected to the first means of connection for detecting photoconduction currents of the two detector elements, the said currents comprising currents due to the wavelength to be detected ($I_1$, $I_2$) and dark currents or dark currents and scene currents ($I_{1opt}$, $I_{2opt}$)

 **characterized in that**:

 - the two detector elements are photoconductors at the same wavelength;
 - the control voltage applied to the second means of connection ($V_1$) or the control voltage applied to the third means of connection ($V_2$) is adjusted in such a way as to adjust the dark currents ($I_{1d}$, $I_{2d}$) in the two active detector elements ($D_1$, $D_2$) ;
 - the means for detecting the photoconduction currents of the two detector elements detect the difference between the currents due to the wavelength $\lambda$ ($I_1$ - $I_2$).

2. Detector according to Claim 1, **characterized in that** the common layer (Cc) is an electrical contact layer, the first means of connection (Pc) being connected to this common layer and **in that** the assembly of the two detector elements is tightly sandwiched between two contact electrical control layers (C1, C2), the second and the third means of connection (P1, P2) each being connected to a contact control layer.

3. Detector according to Claim 1, **characterized in that** the common layer (Cc) is an insulant layer, **in that** the first means of connection is connected to a first end of each detector element, and **in that** the second and the third means of connection are each connected to a second end of a detector element, the first end and the second end of each detector element being opposite ends of said detector element.

4. Detector according to Claim 1, **characterized in that** the response of one of the detector elements is markedly greater than the response of the other detector element in such a way that it absorbs almost all of the light energy at the wavelength for which it is photoconductive.

5. Detector according to one of Claims 1 or 2, **characterized in that** the common layer (Cc) is not transparent to the wavelength to be detected so that the active layer of one of the detector elements (D1) does not receive this wavelength.

6. Detector according to Claim 1, **characterized in that** one of the potentials of the second or third means of connection is set in such a way that the dark currents or the sums of the dark currents and scene currents of the two detector elements are equal.

7. Detector **characterized in that** it includes a matrix of detectors according to Claim 2, made on a substrate, a first contact control layer (C2) being on the face of the substrate and being common to all the detectors, each detector including, on this first contact control layer, a first detector element (D2) made of photoconductive material, a contact reading layer (Cc), a second detector element (D1) made of photoconductive material, a second contact control layer (C2), the second contact control layers (C2) of the various detectors of the matrix being interconnected.

8. Detector according to Claim 7, **characterized in that** it includes a matrix of row conductors and column conductors which is superposed on the matrix of detectors, each detector being located substantially at a crossover point of the matrix of row and column conductors and being connectable to the column wire of the crossover point by a switching device controllable by a potential applied to the row wire of the crossover point.

9. Detector according to Claim 7, **characterized in that**:

 - the first contact control layer (C2) is made in the form of strips, a row of detectors being made on each strip;

 **in that**:

 - the second contact layers of the detectors of each row of detectors are also interconnected together;

- and **in that** the contact reading layers of a detector of each row of detectors are interconnected together to form columns of detectors.

10. Detector **characterized in that** it comprises a matrix of detectors according to Claim 3, made on a substrate, a conducting layer (C3) being on the face of the substrate and being common to all the detectors, this layer being covered with an insulant layer (IS1), each detector comprising, on this insulant layer, a first detector element (D2) made of photoconducting material, a common insulant layer (Cc), a second detector element (D1) made of photoconducting material, the second connection elements being connected together as are the third connection elements.

**Patentansprüche**

1. Detektor für elektromagnetische Wellen mit Photoleiter, der aufweist:

- mindestens zwei aktive Detektorelemente mit Photoleitern (D1, D2) ebener Form, die gestapelt sind und durch eine gemeinsame Schicht (Cc) getrennt werden;
- ein erstes Verbindungsmittel (Pc), das mit den beiden Detektorelementen gemeinsam verbunden ist, ein zweites Verbindungsmittel (P1), das mit dem ersten Detektormittel verbunden ist, und ein drittes Verbindungsmittel (P2), das mit dem zweiten Detektorelement verbunden ist;
- Mittel, um an jedes Verbindungsmittel Steuerspannungen (V1, V2) anzulegen, wobei ein an das erste Verbindungsmittel angelegtes Potential einen Wert hat, der zwischen den an das zweite und dritte Verbindungsmittel angelegten Potentialen (V1, V2) liegt;
- Mittel, die mit dem ersten Verbindungsmittel verbunden sind, um Photoleitungsströme der beiden Detektorelemente zu erfassen, wobei die Ströme auf die zu erfassende Wellenlänge ($I_1$, $I_2$) zurückzuführende Ströme und Dunkelströme oder Dunkelströme und Szene-Ströme ($I_{1opt}$, $I_{2opt}$) aufweisen,

**dadurch gekennzeichnet, dass**:

- die beiden Detektorelemente auf der gleichen Wellenlänge photoleitend sind;
- die an das zweite Verbindungsmittel angelegte Steuerspannung ($V_1$) oder die an das dritte Verbindungsmittel angelegte Steuerspannung ($V_2$) so geregelt wird, dass die Dunkelströme ($I_{1d}$, $I_{2d}$) in den beiden aktiven Detektorelementen ($D_1$,

$D_2$) geregelt werden;
- die Mittel zur Erfassung der Photoleitungsströme der beiden Detektorelemente die Differenz zwischen den auf die Wellenlänge $\lambda(I_1-I_2)$ zurückzuführenden Ströme erfassen.

2. Detektor nach Anspruch 1, **dadurch gekennzeichnet, dass** die gemeinsame Schicht (Cc) eine elektrische Kontaktschicht ist, wobei das erste Verbindungsmittel (Pc) mit dieser gemeinsamen Schicht verbunden ist, und dass die Einheit der beiden Detektorelemente zwischen zwei Kontaktschichten elektrischer Steuerung (C1, C2) eingeklemmt sind, wobei das zweite und das dritte Verbindungsmittel (P1, P2) je mit einer Steuerkontaktschicht verbunden sind.

3. Detektor nach Anspruch 1, **dadurch gekennzeichnet, dass** die gemeinsame Schicht (Cc) eine isolierende Schicht ist, dass das erste Verbindungsmittel mit einem ersten Ende jedes Detektorelements verbunden ist, und dass das zweite und das dritte Verbindungselement je mit einem zweiten Ende eines Detektorelements verbunden sind, wobei das erste Ende und das zweite Ende jedes Detektorelements einander entgegengesetzte Enden des Detektorelements sind.

4. Detektor nach Anspruch 1, **dadurch gekennzeichnet, dass** die Reaktion eines der Detektorelemente deutlich stärker ist als die Reaktion des anderen Detektorelements, so dass es praktisch die gesamte Lichtenergie bei der Wellenlänge absorbiert, für die es photoleitend ist.

5. Detektor nach einem der Ansprüche 1 oder 2, **dadurch gekennzeichnet, dass** die gemeinsame Schicht (Cc) für die zu erfassende Wellenlänge nicht transparent ist, so dass die aktive Schicht eines der Detektorelemente (D1) diese Wellenlänge nicht empfängt.

6. Detektor nach Anspruch 1, **dadurch gekennzeichnet, dass** eines der Potentiale des zweiten oder des dritten Verbindungsmittels so geregelt wird, dass die Dunkelströme oder die Summen der Dunkel- und Szene-Ströme der beiden Detektorelemente gleich sind.

7. Detektor, **dadurch gekennzeichnet, dass** er eine Matrix aus Detektoren nach Anspruch 2 aufweist, die auf einem Substrat hergestellt ist, wobei eine erste Steuerkontaktschicht (C2) sich auf der Fläche des Substrats befindet und allen Detektoren gemeinsam ist, wobei jeder Detektor auf dieser ersten Steuerkontaktschicht ein erstes Detektorelement (D2) aus photoleitendem Material, eine Lesekontaktschicht (Cc), ein zweites Detektorelement (D1) aus photoleitendem Material, eine zweite Steuerkontaktschicht (C2) aufweist, wobei die zweiten Steuerkontaktschichten (C2) der verschiedenen Detektoren der Matrix miteinander verbunden sind.

8. Detektor nach Anspruch 7, **dadurch gekennzeichnet, dass** er eine Matrix aus Zeilenleitern und Spaltenleitern aufweist, die über die Matrix aus Detektoren gelegt ist, wobei jeder Detektor sich im Wesentlichen an einem Kreuzungspunkt der Matrix aus Zeilenleitern und Spaltenleitern befindet und mit dem Spaltendraht des Kreuzungspunkts über eine Schaltvorrichtung verbindbar ist, die von einem Potential gesteuert werden kann, das an den Zeilendraht des Kreuzungspunkts angelegt wird.

9. Detektor nach Anspruch 7, **dadurch gekennzeichnet, dass**:

> - die erste Steuerkontaktschicht (C2) in Form von Streifen hergestellt ist, wobei eine Zeile von Detektoren auf jedem Streifen ausgebildet ist;

dass:

> - die zweiten Kontaktschichten der Detektoren jeder Zeile von Detektoren auch miteinander verbunden sind;
> - und dass die Lesekontaktschichten eines Detektors jeder Zeile von Detektoren miteinander verbunden sind, um Spalten von Detektoren zu bilden.

10. Detektor, **dadurch gekennzeichnet, dass** er eine Matrix aus Detektoren nach Anspruch 3 aufweist, die auf einem Substrat ausgebildet ist, wobei eine leitende Schicht (C3) sich auf der Fläche des Substrats befindet und allen Detektoren gemeinsam ist, wobei diese Schicht mit einer isolierenden Schicht (IS1) bedeckt ist, wobei jeder Detektor auf dieser isolierenden Schicht ein erstes Detektorelement (D2) aus photoleitendem Material, eine gemeinsame isolierende Schicht (Cc), ein zweites Detektorelement (D1) aus photoleitendem Material aufweist, wobei die zweiten Verbindungselemente wie auch die dritten Verbindungselemente miteinander verbunden sind.

COUCHE ACTIVE D1

COUCHE ACTIVE D2

SUBSTRAT

RZ

FIG.1a

V2        V1        RÉSEAU
DE DIFFRACTION          LECTURE DU PIXEL

P2        P1        C1        Pc

IS        COUCHE ACTIVE D1        Cc

COUCHE ACTIVE D2        C2

SUBSTRAT

RZ

FIG.2

FIG.1b

FIG.3a

FIG.3b

C1
D1
Cc
D2
C2

SUBSTRAT

## FIG.4a

C1
D1
Cc
D2
C2

SUBSTRAT

## FIG.4b

C1
D1
Cc
D2
C2

SUBSTRAT

## FIG.4c

FIG.5

FIG.6

FIG.7

FIG.8

**FIG.9**